# EUROPEAN PATENT APPLICATION

(11) **EP 4 600 040 A1**
(43) Date of publication of application: **13.08.2025**
(21) Application number: 24748810.9
(22) Date of filing: 12.01.2024
(51) Int. Cl.: B41F 15/08, B41M 1/12

(54) **METHOD FOR SCREEN PRINTING ON SUBSTRATE, PRINTING DEVICE, AND SOLAR CELL**

(30) Priority: 27.12.2023 CN 202311823198
(71) Applicant: Suzhou Maxwell Technologies Co., Ltd., Suzhou, Jiangsu 215200 (CN)
(72) Inventor: TANG, Wei, Suzhou, Jiangsu 215200 (CN); ZHOU, Jian, Suzhou, Jiangsu 215200 (CN); LI, Qiang, Suzhou, Jiangsu 215200 (CN); CHEN, Yu, Suzhou, Jiangsu 215200 (CN)
(74) Representative: Proi World Intellectual Property GmbH
(86) International application number: PCT/CN2024/071969
(87) International publication number: WO 2025/138350

(57) **Abstract**

The present invention discloses a method for screen printing on a substrate, a printing device, and a solar cell, to improve printing efficiency and achieve a good printing effect. The method includes: transporting a to-be-printed substrate to a printing station; moving a screen to a predetermined printing position, where the screen is located above the to-be-printed substrate, and a paste is on the screen; and controlling a printing apparatus to move on the screen, and performing paste deposition on an upper surface of the same to-be-printed substrate at least twice, to complete printing.

## Description

### TECHNICAL FIELD

The present invention relates to the printing technology of batteries, and specifically, to a method for screen printing on a substrate, a printing device, and a solar cell.

### BACKGROUND

Currently, a silicon-based heterojunction solar cell is a common high-efficiency solar cell technology. As a lateral carrier transport layer, a transparent conductive film TCO is an indispensable part of the silicon-based heterojunction solar cell. Silver gate electrodes are formed on the transparent conductive film by screen printing. Silver gate electrodes are usually formed by using overprinting techniques. In the related art, two printing stations are arranged to obtain a gate line with a high aspect ratio. After first printing is performed on the transparent conductive film by using a screen, a second printing station is entered. At the second printing station, second printing is performed on the transparent conductive film by using the screen again, to form a second deposition paste. After printing is performed twice, the gate line has a high aspect ratio. The aspect ratio is a ratio of a height to a width of the gate line. In the related art, the aspect ratio of the gate line prepared by screen printing is usually 24% or less. Screen printing in the related art has a long operating period, causing low efficiency.

### SUMMARY

The technical problem to be resolved in the present invention is to provide a method for screen printing on a substrate, a printing device, and a solar cell, to improve printing efficiency and achieve a good printing effect.

In order to solve the above technical problem, the present invention adopts the following technical solution.

According to a first aspect, a method for screen printing on a substrate is provided in the solution. The method includes:
transporting a to-be-printed substrate to a printing station;
moving a screen to a predetermined printing position, where the screen is located above the to-be-printed substrate, and a paste is on the screen; and
controlling a printing apparatus to move on the screen, and performing paste deposition on an upper surface of the same to-be-printed substrate at least twice, to complete printing.

In a preferred embodiment, paste deposition is performed on the upper surface of the same to-be-printed substrate twice, to complete printing.

In a preferred embodiment, the controlling a printing apparatus to move on the screen includes: controlling the printing apparatus to move from a first side of the screen to a second side opposite to the first side, to complete first paste deposition, so that a first deposition paste is formed on the upper surface of the to-be-printed substrate; and controlling the printing apparatus to move from the second side to the first side of the screen, to complete second paste deposition, so that a second deposition paste is formed on the upper surface of the to-be-printed substrate, and the second deposition paste is at least partially stacked on the first deposition paste.

In a preferred embodiment, the printing apparatus includes a first processing head assembly having a squeegee and a second processing head assembly having a squeegee; during the first paste deposition, the squeegee of the first processing head assembly is lowered to come into contact with a surface of the screen, the squeegee of the second processing head assembly is not in contact with the surface of the screen, and first paste deposition is completed by using the squeegee of the first processing head assembly; and during the second paste deposition, the squeegee of the second processing head assembly is lowered to come into contact with the surface of the screen, the squeegee of the first processing head assembly is raised to come out of contact with the surface of the screen, and second paste deposition is completed by using the squeegee of the second processing head assembly.

In a preferred embodiment, an amount of pastes deposited onto the to-be-printed substrate during the first paste deposition is less than an amount of pastes deposited onto the to-be-printed substrate during the second paste deposition.

In a preferred embodiment, hardness of the squeegee of the first processing head assembly is greater than hardness of the squeegee of the second processing head assembly.

In a preferred embodiment, the squeegee of the first processing head assembly is a steel blade, and the squeegee of the second processing head assembly is a rubber strip blade.

In a preferred embodiment, a force applied by the squeegee of the first processing head assembly to the screen during the first paste deposition is less than a force applied by the squeegee of the second processing head assembly to the screen during the second paste deposition.

In a preferred embodiment, during the first paste deposition, an included angle between the screen and the squeegee of the first processing head assembly is in a range of 30 degrees to 90 degrees; and during the second paste deposition, an included angle between the screen and the squeegee of the second processing head assembly is in a range of 30 degrees to 90 degrees.

In a preferred embodiment, the controlling a printing apparatus to move on the screen includes: controlling the printing apparatus to move from a first side of the screen to a second side opposite to the first side, to complete first paste deposition, so that a first deposition paste is formed on the upper surface of the to-be-printed substrate; controlling the printing apparatus to move from the second side to the first side of the screen, to perform flooding on the screen; and controlling the printing apparatus to move from the first side to the second side of the screen, to complete second paste deposition, so that a second deposition paste is formed on the upper surface of the to-be-printed substrate, and the second deposition paste is at least partially stacked on the first deposition paste.

In a preferred embodiment, the printing apparatus includes a first processing head assembly having a flood blade and a second processing head assembly having a squeegee; during the flooding, the flood blade of the first processing head assembly is lowered, the squeegee of the second processing head assembly is not in contact with a surface of the screen, and flooding is completed by using the flood blade of the first processing head assembly; and during the first paste deposition and the second paste deposition, the squeegee of the second processing head assembly is lowered to come into contact with the surface of the screen, the flood blade of the first processing head assembly is raised to come out of contact with the surface of the screen, and paste deposition is completed by using the squeegee of the second processing head assembly.

In a preferred embodiment, the controlling a printing apparatus to move on the screen includes: controlling the printing apparatus to move from a first side of the screen to a second side opposite to the first side, to complete first paste deposition and second paste deposition, where during the first paste deposition, a first deposition paste is formed on the upper surface of the to-be-printed substrate; and during the second paste deposition, a second deposition paste is formed on the upper surface of the to-be-printed substrate, and the second deposition paste is at least partially stacked on the first deposition paste.

In a preferred embodiment, the printing apparatus includes a first processing head assembly, a second processing head assembly, a third processing head assembly, and a fourth processing head assembly that each have a squeegee; and the controlling the printing apparatus to move from a first side of the screen to a second side opposite to the first side, to complete first paste deposition and second paste deposition includes: lowering the squeegee of the first processing head assembly and the squeegee of the third processing head assembly to come into contact with a surface of the screen; and the squeegee of the second processing head assembly and the squeegee of the fourth processing head assembly are not in contact with the surface of the screen; and controlling the printing apparatus to move from the first side of the screen to the second side opposite to the first side, to complete first paste deposition by using the squeegee of the third processing head assembly and complete second paste deposition by using the squeegee of the first processing head assembly.

In a preferred embodiment, the first processing head assembly, the second processing head assembly, the third processing head assembly, and the fourth processing head assembly are sequentially arranged along a movement direction of the printing apparatus.

In a preferred embodiment, an amount of pastes deposited onto the to-be-printed substrate and moved by the squeegee of the third processing head assembly is less than an amount of pastes deposited onto the to-be-printed substrate and moved by the squeegee of the first processing head assembly.

In a preferred embodiment, a force applied by the squeegee of the third processing head assembly to the screen during the first paste deposition is less than a force applied by the squeegee of the first processing head assembly to the screen during the second paste deposition.

In a preferred embodiment, the method further includes: replacing another to-be-printed substrate after printing is completed; and controlling the printing apparatus to move from the second side to the first side of the screen, to complete first paste deposition and second paste deposition on the another to-be-printed substrate.

In a preferred embodiment, the controlling the printing apparatus to move from the second side to the first side of the screen, to complete first paste deposition and second paste deposition on the another to-be-printed substrate includes: raising the squeegee of the first processing head assembly and the squeegee of the third processing head assembly to come out of contact with a surface of the screen; lowering the squeegee of the second processing head assembly and the squeegee of the fourth processing head assembly to come into contact with the surface of the screen; and controlling the printing apparatus to move from the second side to the first side of the screen, to complete first paste deposition by using the squeegee of the second processing head assembly and complete second paste deposition by using the squeegee of the fourth processing head assembly.

In a preferred embodiment, an amount of pastes deposited onto the to-be-printed substrate and moved by the squeegee of the second processing head assembly is less than an amount of pastes deposited onto the to-be-printed substrate and moved by the squeegee of the fourth processing head assembly.

In a preferred embodiment, the squeegee of the first processing head assembly and the squeegee of the fourth processing head assembly are made of a first material, and the squeegee of the second processing head assembly and the squeegee of the third processing head assembly are made of a second material.

In a preferred embodiment, hardness of the second material is greater than hardness of the first material.

In a preferred embodiment, both the squeegee of the first processing head assembly and the squeegee of the fourth processing head assembly are rubber strip blades; and both the squeegee of the second processing head assembly and the squeegee of the third processing head assembly are steel blades.

In a preferred embodiment, a force applied by the squeegee of the second processing head assembly to the screen during the first paste deposition is less than a force applied by the squeegee of the fourth processing head assembly to the screen during the second paste deposition.

In a preferred embodiment, during the first paste deposition, an included angle between the screen and the squeegee of the third processing head assembly is in a range of 30 degrees to 90 degrees, and an included angle between the screen and the squeegee of the second processing head assembly is in a range of 30 degrees to 90 degrees; and during the second paste deposition, an included angle between the screen and the squeegee of the first processing head assembly is in a range of 30 degrees to 90 degrees, and an included angle between the screen and the squeegee of the fourth processing head assembly is in a range of 30 degrees to 90 degrees.

**In** a preferred embodiment, the printing apparatus includes a first processing head assembly having a squeegee and a second processing head assembly having a squeegee; and the controlling the printing apparatus to move from a first side of the screen to a second side opposite to the first side, to complete first paste deposition and second paste deposition includes: lowering the squeegee of the first processing head assembly and the squeegee of the second processing head assembly to come into contact with a surface of the screen, where a paste is located on the screen, the paste is respectively arranged in correspondence with the squeegee of the first processing head assembly and the squeegee of the second processing head assembly, and the paste is respectively arranged in front of a movement direction of the squeegee of the first processing head assembly and the squeegee of the second processing head assembly; and controlling the printing apparatus to move from the first side of the screen to the second side opposite to the first side, to complete first paste deposition by using the squeegee of the second processing head assembly and complete second paste deposition by using the squeegee of the first processing head assembly.

In a preferred embodiment, the method further includes: replacing another to-be-printed substrate after printing is completed; locating the screen above the another to-be-printed substrate; and adjusting the printing apparatus, so that the paste is respectively located in front of a direction in which the squeegee of the first processing head assembly and the squeegee of the second processing head assembly are to be moved; and controlling the printing apparatus to move from the second side to the first side of the screen, to complete first paste deposition and second paste deposition on the another to-be-printed substrate.

In a preferred embodiment, the controlling a printing apparatus to move on the screen includes: controlling the printing apparatus to move from a first side of the screen to a second side opposite to the first side, to implement first paste deposition and first flooding; and controlling the printing apparatus to move from the second side to the first side of the screen, to implement second paste deposition and second flooding, where during the second paste deposition, a second deposition paste is formed on the upper surface of the to-be-printed substrate, and the second deposition paste is at least partially stacked on the first deposition paste.

In a preferred embodiment, the printing apparatus includes a first processing head assembly having a flood blade, a second processing head assembly having a squeegee, a third processing head assembly having a squeegee, and a fourth processing head assembly having a flood blade; and the implementing first paste deposition and first flooding includes: lowering the flood blade of the first processing head assembly and the squeegee of the third processing head assembly, so that the squeegee of the third processing head assembly comes into contact with a surface of the screen, and both the squeegee of the second processing head assembly and the flood blade of the fourth processing head assembly are not in contact with the surface of the screen; and controlling the printing apparatus to move from the first side to the second side of the screen; and implementing paste deposition by using the squeegee of the third processing head assembly, to form a first deposition paste on the upper surface of the to-be-printed substrate; and implementing first flooding on the screen by using the flood blade of the first processing head assembly.

In a preferred embodiment, the implementing second paste deposition and second flooding includes:
lowering the squeegee of the second processing head assembly and the flood blade of the fourth processing head assembly, so that the squeegee of the second processing head assembly comes into contact with the surface of the screen; raising the flood blade of the first processing head assembly and the squeegee of the third processing head assembly to come out of contact with the surface of the screen; and controlling the printing apparatus to move from the second side to the first side of the screen, to complete paste deposition by using the squeegee of the second processing head assembly, so that a second deposition paste is formed on the upper surface of the to-be-printed substrate, and the second deposition paste is at least partially stacked on the first deposition paste; and implement second flooding on the screen by using the flood blade of the fourth processing head assembly.

In a preferred embodiment, the printing apparatus includes a first processing head assembly having a squeegee, a second processing head assembly having a flood blade, a third processing head assembly having a squeegee, and a fourth processing head assembly having a flood blade.

In a preferred embodiment, the first processing head assembly, the second processing head assembly, the third processing head assembly, and the fourth processing head assembly are sequentially arranged along a movement direction of the printing apparatus.

In a preferred embodiment, the controlling the printing apparatus to move from a first side of the screen to a second side, to complete first paste deposition and second paste deposition on the to-be-printed substrate includes: lowering the squeegee of the first processing head assembly and the squeegee of the third processing head assembly to come into contact with a surface of the screen; and controlling the printing apparatus to move from the first side to the second side of the screen, to complete first paste deposition by using the squeegee of the third processing head assembly and complete second paste deposition by using the squeegee of the first processing head assembly, where the second deposition paste is at least partially stacked on the first deposition paste.

In a preferred embodiment, after the completing first paste deposition and second paste deposition, the method further includes: raising the squeegee of the first processing head assembly and the squeegee of the third processing head assembly to come out of contact with the surface of the screen, and lowering the flood blade of the second processing head assembly and the flood blade of the fourth processing head assembly; and controlling the printing apparatus to move from the second side to the first side of the screen, and complete flooding by using the flood blade of the second processing head assembly and the flood blade of the fourth processing head assembly.

In a preferred embodiment, no heat treatment process is performed between two paste deposition processes.

According to a second aspect, a printing device is provided in the solution. The printing device uses the method for screen printing on a substrate as described above.

According to a third aspect, a solar cell is provided in the solution. The solar cell is prepared by using the method for screen printing on a substrate as described above.

According to a fourth aspect, a solar cell assembly is provided in the solution. The solar cell assembly is prepared by using a plurality of solar cells as described above.

Compared with the related art, the method in this embodiment of the present invention may improve operation efficiency and achieve a good printing effect. The method in this embodiment includes: transporting a to-be-printed substrate to a printing station; moving a screen to a predetermined printing position, where the screen is located above the to-be-printed substrate, and a paste is on the screen; and controlling a printing apparatus to move on the screen, and performing paste deposition on an upper surface of the same to-be-printed substrate at least twice, to complete printing. Paste deposition is performed at the same station at least twice, so that operation efficiency is improved, and an aspect ratio of a gate line obtained after printing is high, which may be 0.5 or higher.

### BRIEF DESCRIPTION OF THE DRAWINGS

FIG. 1 is a schematic diagram of a first procedure according to a first preferred embodiment of the present invention;
FIG. 2 is a schematic diagram of a second procedure according to a first preferred embodiment of the present invention;
FIG. 3 is a schematic diagram of a first procedure according to a second preferred embodiment of the present invention;
FIG. 4 is a schematic diagram of a second procedure according to a second preferred embodiment of the present invention;
FIG. 5 is a schematic diagram of a third procedure according to a second preferred embodiment of the present invention;
FIG. 6 is a schematic diagram of a first procedure according to a third preferred embodiment of the present invention;
FIG. 7 is a schematic diagram of a second procedure according to a third preferred embodiment of the present invention;
FIG. 8 is a schematic diagram of a first procedure according to a fourth preferred embodiment of the present invention;
FIG. 9 is a schematic diagram of a second procedure according to a fourth preferred embodiment of the present invention;
FIG. 10 is a schematic diagram of a first procedure according to a fifth preferred embodiment of the present invention;
FIG. 11 is a schematic diagram of a second procedure according to a fifth preferred embodiment of the present invention;
FIG. 12 is a schematic diagram of a first procedure according to a sixth preferred embodiment of the present invention;
FIG. 13 is a schematic diagram of a second procedure according to a sixth preferred embodiment of the present invention;
FIG. 14 is a schematic structural diagram of a printing part in the present invention; and
FIG. 15 is a schematic structural diagram of a printing apparatus in the present invention.

### DETAILED DESCRIPTION

The following describes the technical solutions of the present invention in detail with reference to accompanying drawings.

The present application is widely applied. In one example, a substrate is a silicon-based solar cell formed with a transparent conductive layer. Printing on a to-be-printed substrate is to print on the transparent conductive layer to form a gate electrode.

An embodiment of the present invention provides a method for screen printing on a substrate, including:
Step 10: Transport a to-be-printed substrate to a printing station. For example, the to-be-printed substrate is transported to the printing station by using a conveyor belt, a rotary table, or in another transport manner. Printing on the to-be-printed substrate is implemented at the printing station.
Step 20: Move a screen to a predetermined printing position, where the screen is located above the to-be-printed substrate, and a paste is on the screen. After the to-be-printed substrate is transported to the printing station, the screen is moved to the predetermined printing position, so that the screen is located above the to-be-printed substrate.
Step 30: Control a printing apparatus to move on the screen, and perform paste deposition on an upper surface of the same to-be-printed substrate at least twice, to complete printing. During printing, the paste is pushed by the printing apparatus to be moved, so that the paste is deposited onto the to-be-printed substrate through the screen.

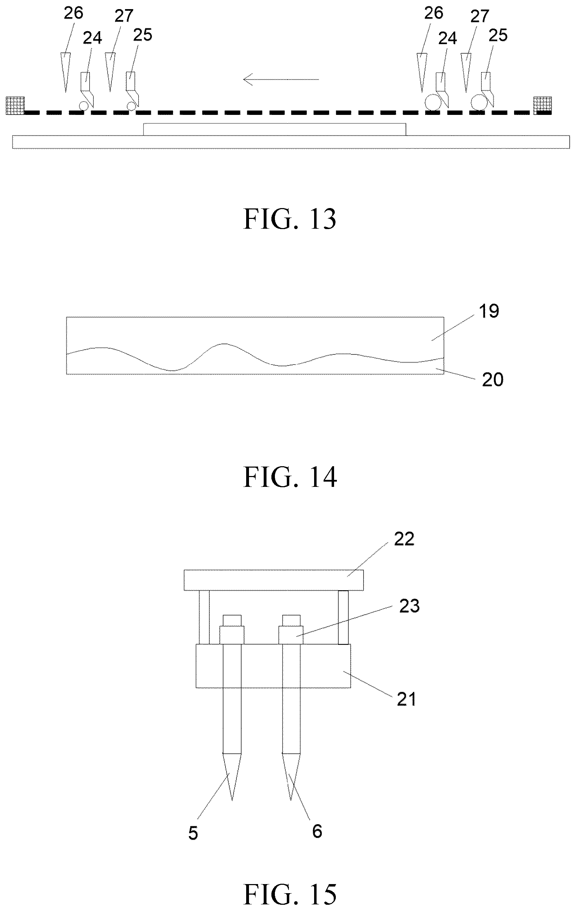

Compared with the related art in which printing is completed through one-time paste deposition on the to-be-printed substrate, in this embodiment, paste deposition is performed on the upper surface of the same to-be-printed substrate at least twice, to complete printing. As shown in FIG. 14, a printing part formed on the upper surface of the same to-be-printed substrate includes a first deposition paste 20 located on a lower portion and a second deposition paste 19 located on an upper portion. At the same station, a number of times for which paste deposition is performed is increased, and an aspect ratio of a gate line obtained after printing may be 25% or higher. In addition, compared with existing multi-station printing, in the method of this embodiment, paste deposition is performed at the same station for a plurality of times, which significantly improves operation efficiency.

In the related art, after first printing is performed on the transparent conductive film layer by using the screen, heat treatment, such as baking needs to be performed on the first deposition paste, and then a second printing station is entered. At the second printing station, second printing is performed on the transparent conductive film by using the screen again, to form a second deposition paste. In the foregoing embodiment, no heat treatment process is performed between two paste deposition processes. The method eliminates an existing paste drying heat treatment process, simplifies processes, and increases efficiency.

In a preferred embodiment, paste deposition is performed on the upper surface of the same to-be-printed substrate twice, to complete printing. After two paste depositions, the gate line may have a high aspect ratio. By reducing the number of times for which paste deposition is performed while ensuring the printing effect, the operation efficiency may be improved, a structure of a printing device may be made simpler, and manufacturing costs of the device may be reduced.

The printing apparatus in this embodiment, as shown in FIG. 15, includes a processing head assembly, a lifting apparatus 23, a base 21, and a horizontal moving apparatus 22. The processing head assembly is connected to the lifting apparatus 23, the lifting apparatus 23 is connected to the base 21, and the base 21 is connected to the horizontal moving apparatus 22. Main structures of processing head assemblies are the same, for example, a first processing head assembly, a second processing head assembly, a third processing head assembly, and a fourth processing head assembly described herein are of the same main construction. The processing head assembly includes a bracket and a knife that is connected to the bottom of the bracket. The lifting apparatus drives the processing head assembly to move up and down, and the horizontal moving apparatus 22 drives the processing head assembly to move in a horizontal plane, for example, move leftward and rightward. Preferably, the horizontal moving apparatus 22 drives all processing head assemblies to synchronously move in the horizontal plane. The knife may be a squeegee or a flood blade. A plurality of processing head assemblies may be arranged in the same printing apparatus. As shown in FIG. 15, the printing apparatus includes two processing head assemblies. The squeegee or the flood blade is selected according to an actual situation. The same printing apparatus may drive all knives to synchronously and horizontally move, and may further separately adjust raising and lowering of a single processing head assembly.

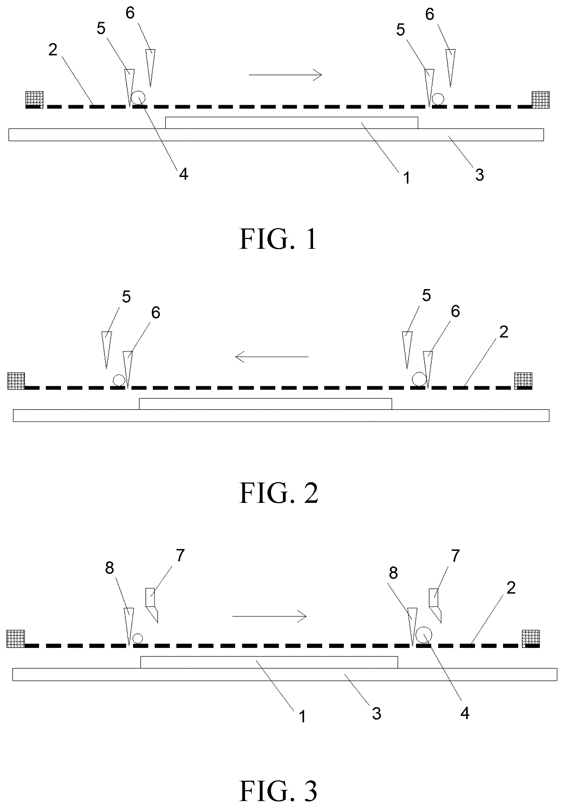

In a first preferred embodiment, as shown in FIG. 1, the printing apparatus includes a first processing head assembly having a squeegee 5 and a second processing head assembly having a squeegee 6. The first processing head assembly and the second processing head assembly are arranged along a movement direction of the printing apparatus.

In step 30, the controlling a printing apparatus to move on the screen includes the following steps:
Step 3011: Control the printing apparatus to move from a first side of a screen 2 to a second side opposite to the first side, to complete first paste deposition, so that a first deposition paste is formed on the upper surface of the to-be-printed substrate.

The first side and the second side are opposite sides of the screen. As indicated by an arrow in FIG. 1, the printing apparatus moves from the first side to the second side of the screen. As indicated by an arrow in FIG. 2, the printing apparatus moves from the second side to the first side of the screen. During the first paste deposition, the squeegee of the first processing head assembly is lowered to come into contact with a surface of the screen, the squeegee of the second processing head assembly is not in contact with the surface of the screen, and first paste deposition is completed by using the squeegee of the first processing head assembly. As shown in FIG. 1, during the first paste deposition, only the squeegee 5 of the first processing head assembly is in contact with the screen 2. A paste 4 moves on the surface of the screen 2 as the squeegee 5 of the first processing head assembly moves. During movement of the paste 4, part of the paste is deposited onto an upper surface of a to-be-printed substrate 1, to form a first deposition paste. During the first paste deposition, the squeegee 6 of the second processing head assembly is not in contact with the surface of the screen 2 and does not apply a force on the paste.

Step 3012: Control the printing apparatus to move from the second side to the first side of the screen, to complete second paste deposition, so that a second deposition paste is formed on the upper surface of the to-be-printed substrate, and the second deposition paste is at least partially stacked on the first deposition paste.

During the second paste deposition, as shown in FIG. 2, the squeegee 6 of the second processing head assembly is lowered to come into contact with the surface of the screen 2, the squeegee 5 of the first processing head assembly is raised to come out of contact with the surface of the screen 2, and second paste deposition is completed by using the squeegee 6 of the second processing head assembly. During the second paste deposition, the squeegee 6 of the second processing head assembly is in contact with the surface of the screen 2. The squeegee 6 of the second processing head assembly drives the paste 4 to move on the surface of the screen 2. During movement of the paste, part of the paste is deposited onto the to-be-printed substrate 1, to form a second deposition paste. The second deposition paste is at least partially stacked on the first deposition paste.

In this embodiment, the first deposition paste is equivalent to a substrate. The second deposition paste and the first deposition paste integrally form the print part. In this embodiment, the printing apparatus reciprocally moves once between the first side and the second side of the screen, that is, moved for a total of twice, to implement two paste depositions on the same to-be-printed substrate.

In this embodiment, an amount of pastes deposited onto the to-be-printed substrate during the first paste deposition is equal to or greater than an amount of pastes deposited onto the to-be-printed substrate during the second paste deposition. However, preferably, the amount of pastes deposited onto the to-be-printed substrate during the first paste deposition is less than the amount of pastes deposited onto the to-be-printed substrate during the second paste deposition. The first paste deposition has a small amount of pastes and serves as a substrate. The second paste deposition having a larger amount of pastes may fill meshes of the screen, so that a gate line obtained after printing has a high aspect ratio. In addition, the gate line obtained after printing has a more stable structure and is less likely to break.

In this embodiment, hardness of the squeegee of the first processing head assembly is less than or equal to hardness of the squeegee of the second processing head assembly. However, preferably, the hardness of the squeegee of the first processing head assembly is greater than the hardness of the squeegee of the second processing head assembly. In this way, a contact area between the squeegee of the first processing head assembly and the screen is smaller than a contact area between the squeegee of the second processing head assembly and the screen, so that the squeegee of the second processing head assembly scrapes more pastes. Preferably, the squeegee of the first processing head assembly is a steel blade, and the squeegee of the second processing head assembly is a rubber strip blade. The steel blade and the rubber strip blade are preferred, and a person skilled in the art may also use a squeegee made of another material.

In this embodiment, a force applied by the squeegee of the first processing head assembly to the screen during the first paste deposition is equal to or greater than a force applied by the squeegee of the second processing head assembly to the screen during the second paste deposition. However, preferably, the force applied by the squeegee of the first processing head assembly to the screen during the first paste deposition is less than the force applied by the squeegee of the second processing head assembly to the screen during the second paste deposition. In this way, there are fewer pastes in the first paste deposition, and there are more pastes in the second paste deposition. The gate line obtained after printing has a more stable structure and is less likely to break.

In this embodiment, preferably, during the first paste deposition, an included angle between the screen and the squeegee of the first processing head assembly is in a range of 30 degrees to 90 degrees; and during the second paste deposition, an included angle between the screen and the squeegee of the second processing head assembly is in a range of 30 degrees to 90 degrees.

In a second preferred embodiment, the printing apparatus includes a first processing head assembly having a flood blade and a second processing head assembly having a squeegee. The first processing head assembly and the second processing head assembly are arranged along a movement direction of the printing apparatus.

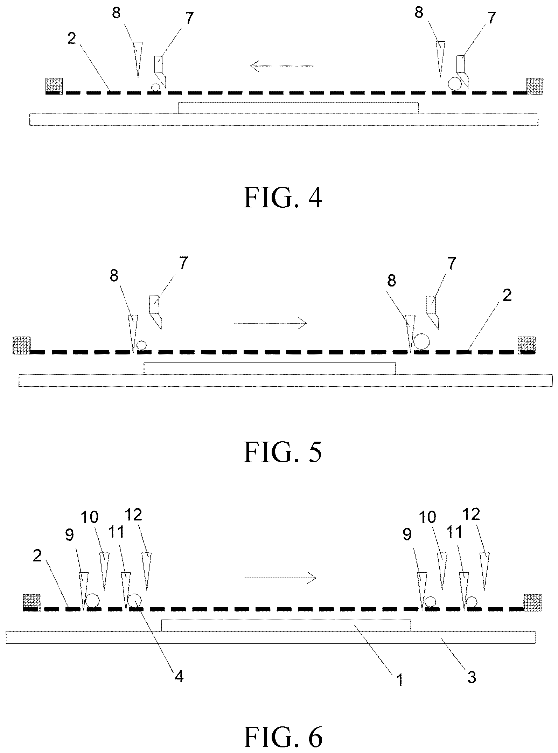

In step 30, the controlling a printing apparatus to move on the screen specifically includes the following steps:
Step 3021: Control the printing apparatus to move from a first side of a screen to a second side opposite to the first side, to complete first paste deposition, so that a first deposition paste is formed on the upper surface of the to-be-printed substrate. As shown in FIG. 3, the printing apparatus moves from a left side to a right side of an illustrated screen. A squeegee 8 of the second processing head assembly is raised to come into contact with the surface of the screen 2. A flood blade 7 of the first processing head assembly is raised to come out of contact with the surface of the screen 2. The squeegee 8 of the second processing head assembly acts on the paste that has been flooded on the screen, so that part of the paste falls off the screen and onto the to-be-printed substrate below the screen, to form a first deposition paste.
Step 3022: Control the printing apparatus to move from the second side to the first side of the screen, to perform flooding on the screen. As shown in FIG. 4, the printing apparatus moves from a right side to a left side of an illustrated screen. The flood blade 7 of the first processing head assembly is lowered to come out of contact with the surface of the screen 2. The squeegee 8 of the second processing head assembly is raised to come out of contact with the surface of the screen 2. The flood blade 7 drives the paste 4 in front of the flood blade to move on the surface of the screen 2. The paste 4 is flooded again onto the surface of the screen 2 by using the flood blade 7 of the first processing head assembly, to complete flooding.
Step 3023: Control the printing apparatus to move from the first side to the second side of the screen, to complete second paste deposition, so that a second deposition paste is formed on the upper surface of the to-be-printed substrate, and the second deposition paste is at least partially stacked on the first deposition paste. As shown in FIG. 5, the printing apparatus moves from a left side to a right side of an illustrated screen. A squeegee 8 of the second processing head assembly is raised to come into contact with the surface of the screen 2. A flood blade 7 of the first processing head assembly is raised to come out of contact with the surface of the screen 2. The squeegee 8 of the second processing head assembly acts on the paste that has been flooded on the screen, so that part of the paste falls off the screen and onto the to-be-printed substrate below the screen, to form a second deposition paste, where the second deposition paste is at least partially stacked on the first deposition paste.

Before step 3021, the method may further include: controlling the printing apparatus to move from the second side to the first side of the screen, to perform flooding on the screen.

In a second preferred embodiment, the flood blade is used in cooperation with the squeegee. Before the squeegee operates, flooding is performed on the screen by using the flood blade. In this way, when the squeegee is in operation, there are sufficient pastes on the screen. In a second preferred embodiment, the printing apparatus needs to reciprocally move twice each, that is, move for a total of four times, to form the first deposition paste and the second deposition paste on the to-be-printed substrate, to complete printing.

It is to be noted that, in this solution, paste deposition may also be performed for three times or more than three times. This is not further described herein.

In a third preferred embodiment, the printing apparatus includes a first processing head assembly having a squeegee, a second processing head assembly having a squeegee, a third processing head assembly having a squeegee, and a fourth processing head assembly having a squeegee. The first processing head assembly, the second processing head assembly, the third processing head assembly, and the fourth processing head assembly are sequentially arranged along a movement direction of the printing apparatus.

In step 30, the controlling a printing apparatus to move on the screen specifically includes the following steps:
Step 3031: Control the printing apparatus to move from a first side of the screen to a second side opposite to the first side, to complete first paste deposition and second paste deposition, where during the first paste deposition, a first deposition paste is formed on the upper surface of the to-be-printed substrate; and during the second paste deposition, a second deposition paste is formed on the upper surface of the to-be-printed substrate, and the second deposition paste is at least partially stacked on the first deposition paste. The completing first paste deposition and second paste deposition, the method further includes the following steps:
Step 30311: As shown in FIG. 6, lower a squeegee 9 of the first processing head assembly and a squeegee 11 of the third processing head assembly to come into contact with a surface of the screen 2, where a squeegee 10 of the second processing head assembly and a squeegee 12 of the fourth processing head assembly are not in contact with the surface of the screen 2. In the movement direction, the paste 4 is respectively arranged in front of the squeegee 9 of the first processing head assembly and in front of the squeegee 11 of the third processing head assembly.
Step 30312: As shown in FIG. 6, control the printing apparatus to move from a first side of the screen to a second side opposite to the first side, that is, the printing apparatus moves from a left side to a right side as illustrated. The printing apparatus sequentially includes the first processing head assembly having the squeegee 9, the second processing head assembly having the squeegee 10, the third processing head assembly having the squeegee 11, and the fourth processing head assembly having the squeegee 12 along the movement direction. First paste deposition is completed by using the squeegee 11 of the third processing head assembly, and second paste deposition is completed by using the squeegee 9 of the first processing head assembly. The squeegee 11 of the third processing head assembly drives the paste to move on the surface of the screen 2. During movement of the paste 4, part of the paste is deposited onto the to-be-printed substrate 1, to form a first deposition paste. The squeegee 9 of the first processing head assembly drives the paste 4 to move on the surface of the screen 2. During movement of the paste, part of the paste is deposited onto the to-be-printed substrate 1, to form a second deposition paste. The second deposition paste is at least partially stacked on the first deposition paste.

In the foregoing method, the printing apparatus moves from a first side of the screen to a second side opposite to the first side, to complete first paste deposition and second paste deposition. In this process, the printing apparatus moves from one side of the screen to the other side, to complete two paste depositions. Likewise, two paste depositions are completed, a moving path of the printing apparatus in the third preferred embodiment is half of a moving path of the printing apparatus in the first preferred embodiment, and is one quarter of a moving path of the printing apparatus in the second preferred embodiment. The movement path of the printing apparatus in this preferred embodiment is shorter, which greatly improves the operation efficiency.

In step 30312, an amount of pastes deposited onto the to-be-printed substrate and moved by the squeegee of the third processing head assembly is greater than or equal to an amount of pastes deposited onto the to-be-printed substrate and moved by the squeegee of the first processing head assembly. Preferably, the amount of pastes deposited onto the to-be-printed substrate and moved by the squeegee of the third processing head assembly is less than the amount of pastes deposited onto the to-be-printed substrate and moved by the squeegee of the first processing head assembly. The first paste deposition has a small amount of pastes and serves as a substrate. The second paste deposition having a larger amount of pastes may fill meshes of the screen, so that a gate line obtained after printing has a high aspect ratio.

In this embodiment, a force applied by the squeegee of the third processing head assembly to the screen during the first paste deposition is greater than or equal to a force applied by the squeegee of the first processing head assembly to the screen during the second paste deposition. However, preferably, the force applied by the squeegee of the third processing head assembly to the screen during the first paste deposition is less than the force applied by the squeegee of the first processing head assembly to the screen during the second paste deposition. In this way, there are fewer pastes in the first paste deposition, and there are more pastes in the second paste deposition. The gate line obtained after printing has a more stable structure and is less likely to break.

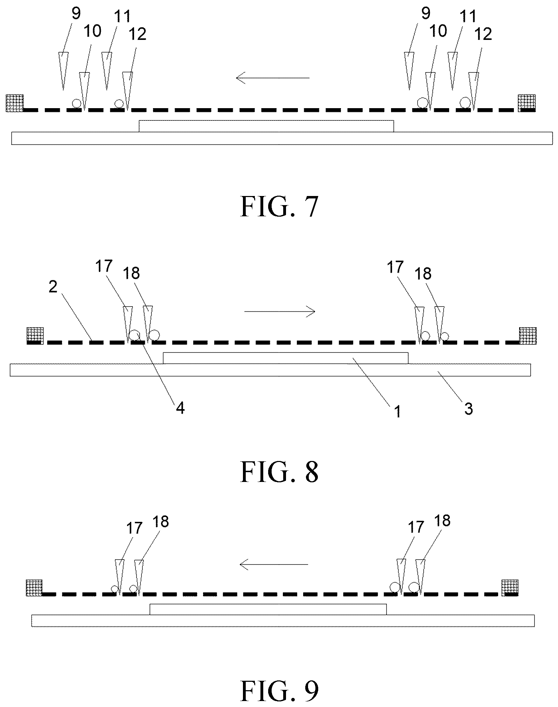

In a third preferred embodiment, step 3031 is followed by step 3032. Step 3032 includes the following steps:
Step 30321: Replace another to-be-printed substrate after printing is completed.
Step 30322: As shown in FIG. 7, control the printing apparatus to move from the second side to the first side of the screen, to complete first paste deposition and second paste deposition on the another to-be-printed substrate.

In step 3031, the printing apparatus moves from the first side to the second side of the screen, to complete printing on the to-be-printed substrate. Then, in step 3032, the printing apparatus moves from a stop position, that is, the second side of the screen, to the first side of the screen, and completes printing on the another to-be-printed substrate. Step 3032 continues movement of the printing apparatus in step 3031, and during the movement of the printing apparatus, two paste depositions are completed on the another to-be-printed substrate. This greatly improves operation efficiency of the printing apparatus.

In a first preferred embodiment, the printing apparatus reciprocally moves once each, to complete printing on one to-be-printed substrate. In a second preferred embodiment, the printing apparatus reciprocally moves twice each, to complete printing on a to-be-printed substrate. In a third preferred embodiment, the printing apparatus reciprocally moves once each, to complete printing of two to-be-printed substrates.

In addition, the printing apparatus sequentially includes the first processing head assembly having the squeegee 9, the second processing head assembly having the squeegee 10, the third processing head assembly having the squeegee 11, and the fourth processing head assembly having the squeegee 12 along the movement direction. After first paste deposition and second paste deposition on the to-be-printed substrate are completed, the paste is respectively located on a side of the squeegee 9 of the first processing head assembly and the squeegee 11 of the third processing head assembly close to the second side of the screen. Therefore, before a printing process is performed on another to-be-printed substrate, the squeegee 9 of the first processing head assembly and the squeegee 11 of the third processing head assembly may be raised, and the squeegee 10 of the second processing head assembly and the squeegee 12 of the fourth processing head assembly may be lowered. In this case, the paste is located on a side of a direction in which the squeegee 10 of the second processing head assembly and the squeegee 12 of the fourth processing head assembly are to be moved. As shown in FIG. 7, such arrangement simplifies processes and improves printing efficiency.

Specifically, in step 30322, the controlling the printing apparatus to move from the second side to the first side of the screen, to complete first paste deposition and second paste deposition on the another to-be-printed substrate, as shown in FIG. 7, includes the following steps:
Step 303221: Raise the squeegee 9 of the first processing head assembly and the squeegee 11 of the third processing head assembly to come out of contact with a surface of the screen 2; and lowering the squeegee 10 of the second processing head assembly and the squeegee 12 of the fourth processing head assembly to come into contact with the surface of the screen 2.
Step 303222: Control the printing apparatus to move from the second side to the first side of the screen, to complete first paste deposition by using the squeegee 10 of the second processing head assembly and complete second paste deposition by using the squeegee 12 of the fourth processing head assembly.

The squeegee 10 of the second processing head assembly operates before the squeegee 12 of the fourth processing head assembly operates. The squeegee 10 of the second processing head assembly drives the paste to move on the surface of the screen. During movement of the paste, part of the paste is deposited onto the to-be-printed substrate, to form a first deposition paste. The squeegee 12 of the fourth processing head assembly drives the paste to move on the surface of the screen 2. During movement of the paste, part of the paste is deposited onto the to-be-printed substrate, to form a second deposition paste. The second deposition paste is at least partially stacked on the first deposition paste.

In the foregoing method, the printing apparatus moves from the second side to the first side of the screen, to complete first paste deposition and second paste deposition on the another to-be-printed substrate.

In step 303222, an amount of pastes deposited onto the to-be-printed substrate and moved by the squeegee of the second processing head assembly is greater than or equal to an amount of pastes deposited onto the to-be-printed substrate and moved by the squeegee of the fourth processing head assembly. Preferably, the amount of pastes deposited onto the to-be-printed substrate and moved by the squeegee of the second processing head assembly is less than the amount of pastes deposited onto the to-be-printed substrate and moved by the squeegee of the fourth processing head assembly. The first paste deposition has a small amount of pastes and serves as a substrate. The second paste deposition having a larger amount of pastes may fill meshes of the screen, so that a gate line obtained after printing has a high aspect ratio.

In the third preferred embodiment, the squeegee of the first processing head assembly and the squeegee of the fourth processing head assembly are made of a first material, and the squeegee of the second processing head assembly and the squeegee of the third processing head assembly are made of a second material. The material of the first material and the second material may be the same. However, preferably, the material of the first material and the second material may be different. Preferably, hardness of the second material is greater than hardness of the first material. In this way, the contact area between the squeegee of the first processing head assembly and the screen is greater than a contact area between the squeegee of the third processing head assembly and the screen, so that the squeegee of the first processing head assembly scrapes more pastes. For example, both the squeegee of the first processing head assembly and the squeegee of the fourth processing head assembly are rubber strip blades; and both the squeegee of the second processing head assembly and the squeegee of the third processing head assembly are steel blades.

In step 303222, a force applied by the squeegee of the second processing head assembly to the screen during the first paste deposition is greater than or equal to a force applied by the squeegee of the fourth processing head assembly to the screen during the second paste deposition. However, preferably, the force applied by the squeegee of the second processing head assembly to the screen during the first paste deposition is less than the force applied by the squeegee of the fourth processing head assembly to the screen during the second paste deposition. The first paste deposition has a small amount of pastes and serves as a substrate. The second paste deposition having a larger amount of pastes may fill meshes of the screen, so that a gate line obtained after printing has a high aspect ratio. In addition, the gate line obtained after printing has a more stable structure and is less likely to break.

Preferably, during first printing, an included angle between the screen and the squeegee of the first processing head assembly is in a range of 30 degrees to 90 degrees; and an included angle between the screen and the squeegee of the third processing head assembly is in a range of 30 degrees to 90 degrees. During second printing, an included angle between the screen and the squeegee of the second processing head assembly is in a range of 30 degrees to 90 degrees, and an included angle between the screen and the squeegee of the fourth processing head assembly is in a range of 30 degrees to 90 degrees.

In a fourth preferred embodiment, the controlling a printing apparatus to move on the screen includes: controlling the printing apparatus to move from a first side of the screen to a second side opposite to the first side, to complete first paste deposition and second paste deposition, where during the first paste deposition, a first deposition paste is formed on the upper surface of the to-be-printed substrate; and during the second paste deposition, a second deposition paste is formed on the upper surface of the to-be-printed substrate, and the second deposition paste is at least partially stacked on the first deposition paste.

In the fourth preferred embodiment, the printing apparatus includes a first processing head assembly having a squeegee 17 and a second processing head assembly having a squeegee 18. The first processing head assembly and the second processing head assembly are arranged along a movement direction of the printing apparatus. The controlling the printing apparatus to move from a first side of the screen to a second side opposite to the first side, to complete first paste deposition and second paste deposition, as shown in FIG. 8, includes the following steps:
Step 3041: Lower the squeegee 17 of the first processing head assembly and the squeegee 18 of the second processing head assembly to come into contact with a surface of the screen 2, where a paste 4 is located on the screen 2, the paste 4 is respectively arranged in correspondence with the squeegee 17 of the first processing head assembly and the squeegee 18 of the second processing head assembly, and the paste 4 is respectively arranged in front of a movement direction of the squeegee 17 of the first processing head assembly and the squeegee 18 of the second processing head assembly.
Step 3042: Control the printing apparatus to move from the first side of the screen 2 to the second side opposite to the first side, to complete first paste deposition by using the squeegee 18 of the second processing head assembly and complete second paste deposition by using the squeegee 17 of the first processing head assembly.

In the fourth preferred embodiment, the printing apparatus moves once, so that two paste depositions on the same to-be-printed substrate may be completed.

After printing is completed, the method further includes the following steps:
Step 3043: Replace another to-be-printed substrate after printing is completed.
Step 3044: Locate the screen above the another to-be-printed substrate; and adjusting the printing apparatus, so that the paste 4 is respectively located in front of a direction in which the squeegee 17 of the first processing head assembly and the squeegee 18 of the second processing head assembly are to be moved. As shown in FIG. 9, the printing apparatus moves from a right side of an illustrated screen to a left side of the screen. At a moving start position, that is, the right side of the screen, there is a paste 4 on a left side of the squeegee 17 of the first processing head assembly, and there is a paste 4 on a left side of the squeegee 18 of the second processing head assembly.
Step 3045: Control the printing apparatus to move from the second side to the first side of the screen, to complete first paste deposition and second paste deposition on the another to-be-printed substrate.

As with the third preferred embodiment, the printing apparatus in the fourth preferred embodiment moves once, so that two paste depositions may be completed, to complete printing. In the third preferred embodiment, when changing the movement direction, the printing apparatus does not need to adjust a horizontal position of the processing head assembly, but merely needs to raise and lower the processing head assembly. However, in the fourth preferred embodiment, when changing the movement direction, the printing apparatus needs to first adjust the horizontal position of the processing head assembly, so that the paste is respectively in front of the squeegee after the movement direction is changed. In this way, the squeegee can drive the paste to move on the screen. After the horizontal position of the processing head assembly is adjusted, the processing head assembly is lowered to bring the squeegee into contact with the screen. Compared with the fourth preferred embodiment, adjustment on the processing head assembly is simpler and more reliable in the third preferred embodiment.

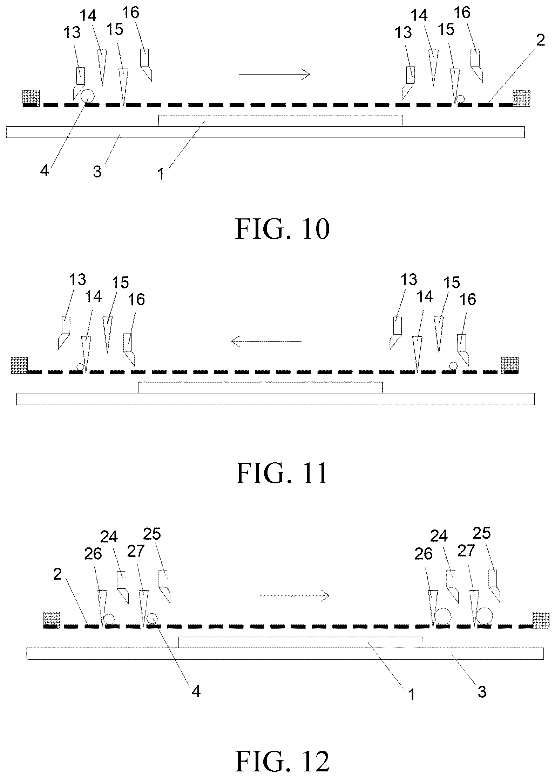

In a fifth preferred embodiment, as shown in FIG. 10, the printing apparatus includes a first processing head assembly having a flood blade 13, a second processing head assembly having a squeegee 14, a third processing head assembly having a squeegee 15, and a fourth processing head assembly having a flood blade 16. The first processing head assembly, the second processing head assembly, the third processing head assembly, and the fourth processing head assembly are sequentially arranged along a movement direction of the printing apparatus.

In step 30, the controlling a printing apparatus to move on the screen specifically includes the following steps:
Step 3051: Control the printing apparatus to move from a first side of the screen to a second side opposite to the first side, to implement first paste deposition and first flooding.
Step 3052: Control the printing apparatus to move from the second side to the first side of the screen, to implement second paste deposition and second flooding, where during the second paste deposition, a second deposition paste is formed on the upper surface of the to-be-printed substrate, and the second deposition paste is at least partially stacked on the first deposition paste.

In step 3051, the implementing first paste deposition and first flooding includes: as shown in FIG. 10, lowering the flood blade 13 of the first processing head assembly and the squeegee 15 of the third processing head assembly, so that the squeegee 15 of the third processing head assembly is in contact with the surface of the screen 2, and the flood blade 13 of the first processing head assembly is not in contact with the surface of the screen 2; and both the squeegee 14 of the second processing head assembly and the flood blade 16 of the fourth processing head assembly are not in contact with the surface of the screen 2; and controlling the printing apparatus to move from the first side to the second side of the screen 2, so that the flood blade 13 of the first processing head assembly is located upstream of the squeegee 15 of the third processing head assembly. Paste deposition is implemented by using the squeegee 15 of the third processing head assembly, to form a first deposition paste on the upper surface of the to-be-printed substrate 1. In this process, a distance between the flood blade 13 of the first processing head assembly and the screen 2 is less than a distance of the flood blade 16 of the fourth processing head assembly and the screen 2. First flooding on the screen 2 is implemented by using the flood blade 13 of the first processing head assembly.

In this embodiment, the squeegee 15 operates before the flood blade 13 operates. The squeegee 15 implements paste deposition. After the squeegee 15 forms the first deposition paste on the upper surface of the to-be-printed substrate 1, the flood blade 13 floods a paste between the squeegee 15 and the flood blade 13 onto the screen in preparation for next doctor of the paste.

Before step 3051, the method further includes: controlling the printing apparatus to move on the screen, to flood the paste onto the screen. At least one of the flood blade of the first processing head assembly and the flood blade of the fourth processing head assembly is lowered, to come out of contact with the surface of the screen, move from one side of the screen to the other side direction, and implement flooding on the screen.

In step 3052, the implement second paste deposition and second flooding includes: as shown in FIG. 11, lowering the squeegee 14 of the second processing head assembly and the flood blade 16 of the fourth processing head assembly, so that the squeegee 14 of the second processing head assembly comes into contact with the surface of the screen 2, and the flood blade 16 of the fourth processing head assembly is not in contact with the screen 2; raising the flood blade 13 of the first processing head assembly and the squeegee 15 of the third processing head assembly to come out of contact with the surface of the screen 2; and controlling the printing apparatus to move from the second side to the first side of the screen 2, so that the flood blade 16 of the fourth processing head assembly is located upstream of the squeegee 14 of the second processing head assembly, to complete paste deposition by using the squeegee 14 of the second processing head assembly, so that a second deposition paste is formed on the upper surface of the to-be-printed substrate, and the second deposition paste is at least partially stacked on the first deposition paste. In this process, the distance between the flood blade 16 of the fourth processing head assembly and the screen 2 is less than the distance between the flood blade 13 of the first processing head assembly and the screen 2, and second flooding on the screen is implemented by using the flood blade 16 of the fourth processing head assembly.

In the fifth preferred embodiment, step 3053 is completed, that is, two paste depositions on the same to-be-printed substrate is completed, and printing is completed. After step 3053, return to step 3052 to circularly operate until printing is finished or the paste on the screen is used and a paste is replenished.

In a fifth preferred embodiment, the printing apparatus needs to be reciprocally move each time, except for initial paste laying, to complete printing on the to-be-printed substrate. In the second preferred embodiment, only one of the squeegee and the flood blade is active during one movement of the printing apparatus, for example from the first side to the second side of the screen. In the fifth preferred embodiment, during one movement of the printing apparatus, the squeegee and the flood blade are active simultaneously.

The flood blade floods a paste between the squeegee for deposition and the flood blade for flooding onto the screen in preparation for next doctor of the paste. Compared with the second preferred embodiment, the fifth preferred embodiment improves the operation efficiency.

In a sixth preferred embodiment, the printing apparatus moves once, so that two paste depositions on the same to-be-printed substrate may be completed, and then flooding is performed by using the flood blade.

In the sixth preferred embodiment, as shown in FIG. 12, the printing apparatus includes a first processing head assembly having a squeegee 26, a second processing head assembly having a flood blade 24, a third processing head assembly having a squeegee 27, and a fourth processing head assembly having a flood blade 25.

Preferably, the first processing head assembly, the second processing head assembly, the third processing head assembly, and the fourth processing head assembly are sequentially arranged along a movement direction of the printing apparatus.

In the sixth preferred embodiment, as shown in FIG. 12, the controlling the printing apparatus to move from a first side of the screen to a second side, to complete first paste deposition and second paste deposition on the to-be-printed substrate includes:
lowering the squeegee 26 of the first processing head assembly and the squeegee 27 the third processing head assembly to come into contact with a surface of the screen; and controlling the printing apparatus to move from the first side to the second side of the screen, to complete first paste deposition by using the squeegee 27 of the third processing head assembly and complete second paste deposition by using the squeegee 26 of the first processing head assembly, where the second deposition paste is at least partially stacked on the first deposition paste.

In the sixth preferred embodiment, as shown in FIG. 13, after the completing first paste deposition and second paste deposition, the method further includes:
raising the squeegee 26 of the first processing head assembly and the squeegee 27 of the third processing head assembly to come out of contact with the surface of the screen, and lowering the flood blade 24 of the second processing head assembly and the flood blade 25 of the fourth processing head assembly; and
controlling the printing apparatus to move from the second side to the first side of the screen, and complete flooding by using the flood blade 24 of the second processing head assembly and the flood blade 25 of the fourth processing head assembly.

Compared with the fifth preferred embodiment, in the sixth preferred embodiment, two successive times of paste deposition on the surface of the same to-be-printed substrate is completed by performing one-time printing, and a printed substrate is transported out of the printing station during flooding by using the flood blade. Alternatively, another to-be-printed substrate may be transported. This operates more efficiently.

In a sixth preferred embodiment, preferably, an amount of pastes deposited onto the to-be-printed substrate during the first paste deposition is less than an amount of pastes deposited onto the to-be-printed substrate during the second paste deposition.

In the sixth preferred embodiment, preferably, hardness of the squeegee of the third processing head assembly is greater than hardness of the squeegee of the first processing head assembly.

In the sixth preferred embodiment, preferably, the squeegee of the third processing head assembly is a steel blade, and the squeegee of the first processing head assembly is a rubber strip blade.

In the sixth preferred embodiment, preferably, the force applied by the squeegee of the third processing head assembly to the screen during the first paste deposition is less than the force applied by the squeegee of the first processing head assembly to the screen during the second paste deposition.

In the sixth preferred embodiment, preferably, during the first paste deposition, an included angle between the screen and the squeegee of the third processing head assembly is in a range of 30 degrees to 90 degrees, and during the second paste deposition, an included angle between the screen and the squeegee of the first processing head assembly is in a range of 30 degrees to 90 degrees.

In the various embodiments and preferred embodiments described above, it is possible to implement, at the same station and through the same screen, two successive times of paste deposition on the surface of the same to-be-printed substrate, to complete printing.

In the various embodiments and preferred embodiments described above, the screen may be a wire screen or a metal screen, which may preferably be a metal mesh. The above embodiment or preferred embodiment allows to implement, at the same station and through the same screen, at least two successive times of paste deposition on the surface of the same to-be-printed substrate, to complete printing. The related art is not adopted, that is, paste drying is performed after first printing, and second printing is performed. In this case, the process is complicated, and alignment is required during the second printing, increasing the process difficulty.

Compared with the related art that uses the screen printing technique, the preferred embodiment uses metal screen printing, and firstly, an amount of deformation of the metal screen is less than an amount of deformation of the screen during the printing. The metal screen has higher alignment accuracy when second paste deposition is performed. Secondly, openings of the metal screen are full openings with no netting present, while the screen may have netting present at the openings. Due to the presence of netting, the screen may further affect uniformity after two paste depositions are stacked. Therefore, based on differences in metal screen and screen printing principles and structures, preferably, the metal screen is chosen as a printing screen. Specifically, the metal screen is a steel mesh, for example, an opening may be formed in the metal screen by laser opening, and compared to the screen, a width of the openings in the steel mesh may be in a range of 5 microns to 15 microns, or may be smaller. In the process of printing by using the metal screen, the paste penetrates through the openings, the first paste deposition and the second paste deposition are more uniform, so that gate lines formed by stacking the first deposition paste and the second deposition paste are narrower and taller, and the aspect ratio of the gate lines obtained after printing is higher, and conductive properties of a battery become better, thereby improving the efficiency of the whole battery. In addition, the printing method of the present invention also improves printing efficiency of a battery sheet, increasing the capacity.

This embodiment further provides a printing device. The printing device performs the method for screen printing on a substrate, and is configured to perform printing on the substrate, thereby improving the operation efficiency and improving the printing effect.

This embodiment further provides a solar cell. The solar cell is prepared by using the method for screen printing on a substrate as described above.

This embodiment further provides a solar cell assembly prepared by using a plurality of solar cells. When the solar cell or the solar cell assembly prepares a gate line by using the printing method of the foregoing embodiments or preferred embodiments, a gate line having a high aspect ratio can be obtained, and a cell conversion rate of the cell can be improved.

The method described in the fourth preferred embodiment is used to print a gate line on a silicon-based solar cell formed with a transparent conductive layer. The screen is a steel mesh. Both the squeegee of the first processing head assembly and the squeegee of the second processing head assembly are steel blades. For the gate lines prepared as described above, heights and widths of the gate lines at 6 different positions are collected, and obtained data is shown in Table 1.

**Table 1**

| | Position 1 | Position 2 | Position 3 | Position 4 | Position 5 | Position 6 | Mean |
|---|---|---|---|---|---|---|---|
| Gate line height (microns) | 13.295 | 13.406 | 13.409 | 13.419 | 13.175 | 12.994 | 13.283 |
| Gate line width (microns) | 24.170 | 25.523 | 22.908 | 26.485 | 25.869 | 26.019 | 25.162 |
| Aspect ratio | 0.550 | 0.525 | 0.585 | 0.507 | 0.509 | 0.499 | 0.528 |

In Table 1, a mean aspect ratio of the 6 different positions is 0.528, which is higher than the aspect ratio of the gate line obtained in the related art. The silicon-based solar cell prepared by using the foregoing method is subjected to cell conversion (ETA) testing. A cell conversion of 26.2% is tested.

The foregoing descriptions are merely preferred implementations of the present invention. It should be noted that a person skilled in the art may be aware that the specific implementations are merely illustrative and are not intended to limit the present invention. Any modification, equivalent replacement, improvement, and the like made by a person under the enlightenment of the present invention shall fall within the protection scope of the present invention.

## Claims

1. A method for screen printing on a substrate, comprising:
transporting a to-be-printed substrate to a printing station;
moving a screen to a predetermined printing position, wherein the screen is located above the to-be-printed substrate, and a paste is on the screen; and
controlling a printing apparatus to move on the screen, and performing paste deposition on an upper surface of the same to-be-printed substrate at least twice, to complete printing.

2. The method according to claim 1, wherein paste deposition is performed on the upper surface of the same to-be-printed substrate twice, to complete printing.

3. The method according to claim 1, wherein the controlling a printing apparatus to move on the screen comprises:
controlling the printing apparatus to move from a first side of the screen to a second side opposite to the first side, to complete first paste deposition to form a first deposition paste on the upper surface of the to-be-printed substrate; and
controlling the printing apparatus to move from the second side to the first side of the screen, to complete second paste deposition, so that a second deposition paste is formed on the upper surface of the to-be-printed substrate, and the second deposition paste is at least partially stacked on the first deposition paste.

4. The method according to claim 3, wherein the printing apparatus comprises a first processing head assembly having a squeegee and a second processing head assembly having a squeegee;
during the first paste deposition, the squeegee of the first processing head assembly is lowered to come into contact with a surface of the screen, the squeegee of the second processing head assembly is not in contact with the surface of the screen, and first paste deposition is completed by using the squeegee of the first processing head assembly; and
during the second paste deposition, the squeegee of the second processing head assembly is lowered to come into contact with the surface of the screen, the squeegee of the first processing head assembly is raised to come out of contact with the surface of the screen, and second paste deposition is completed by using the squeegee of the second processing head assembly.

5. The method according to claim 4, wherein an amount of pastes deposited onto the to-be-printed substrate during the first paste deposition is less than an amount of pastes deposited onto the to-be-printed substrate during the second paste deposition.

6. The method according to claim 4, wherein hardness of the squeegee of the first processing head assembly is greater than hardness of the squeegee of the second processing head assembly.

7. The method according to claim 6, wherein the squeegee of the first processing head assembly is a steel blade, and the squeegee of the second processing head assembly is a rubber strip blade.

8. The method according to claim 4, wherein a force applied by the squeegee of the first processing head assembly to the screen during the first paste deposition is less than a force applied by the squeegee of the second processing head assembly to the screen during the second paste deposition.

9. The method according to claim 4, wherein during the first paste deposition, an included angle between the screen and the squeegee of the first processing head assembly is in a range of 30 degrees to 90 degrees; and during the second paste deposition, an included angle between the screen and the squeegee of the second processing head assembly is in a range of 30 degrees to 90 degrees.

10. The method according to claim 1, wherein the controlling a printing apparatus to move on the screen comprises:
controlling the printing apparatus to move from a first side of the screen to a second side opposite to the first side, to complete first paste deposition, so that a first deposition paste is formed on the upper surface of the to-be-printed substrate;
controlling the printing apparatus to move from the second side to the first side of the screen, to perform flooding on the screen; and
controlling the printing apparatus to move from the first side to the second side of the screen, to complete second paste deposition, so that a second deposition paste is formed on the upper surface of the to-be-printed substrate, and the second deposition paste is at least partially stacked on the first deposition paste.

11. The method according to claim 10, wherein the printing apparatus comprises a first processing head assembly having a flood blade and a second processing head assembly having a squeegee;
during the flooding, the flood blade of the first processing head assembly is lowered, the squeegee of the second processing head assembly is not in contact with a surface of the screen, and flooding is completed by using the flood blade of the first processing head assembly; and
during the first paste deposition and the second paste deposition, the squeegee of the second processing head assembly is lowered to come into contact with the surface of the screen, the flood blade of the first processing head assembly is raised to come out of contact with the surface of the screen, and paste deposition is completed by using the squeegee of the second processing head assembly.

12. The method according to claim 2, wherein the controlling a printing apparatus to move on the screen comprises:
controlling the printing apparatus to move from a first side of the screen to a second side opposite to the first side, to complete first paste deposition and second paste deposition, wherein during the first paste deposition, a first deposition paste is formed on the upper surface of the to-be-printed substrate; and during the second paste deposition, a second deposition paste is formed on the upper surface of the to-be-printed substrate, and the second deposition paste is at least partially stacked on the first deposition paste.

13. The method according to claim 12, wherein the printing apparatus comprises a first processing head assembly, a second processing head assembly, a third processing head assembly, and a fourth processing head assembly that each have a squeegee; and
the controlling the printing apparatus to move from a first side of the screen to a second side opposite to the first side, to complete first paste deposition and second paste deposition comprises:
lowering the squeegee of the first processing head assembly and the squeegee of the third processing head assembly to come into contact with a surface of the screen, wherein the squeegee of the second processing head assembly and the squeegee of the fourth processing head assembly are not in contact with the surface of the screen; and
controlling the printing apparatus to move from the first side of the screen to the second side opposite to the first side, to complete first paste deposition by using the squeegee of the third processing head assembly and complete second paste deposition by using the squeegee of the first processing head assembly.

14. The method according to claim 13, wherein the first processing head assembly, the second processing head assembly, the third processing head assembly, and the fourth processing head assembly are sequentially arranged along a movement direction of the printing apparatus.

15. The method according to claim 13, wherein an amount of pastes deposited onto the to-be-printed substrate and moved by the squeegee of the third processing head assembly is less than an amount of pastes deposited onto the to-be-printed substrate and moved by the squeegee of the first processing head assembly.

16. The method according to claim 13, wherein a force applied by the squeegee of the third processing head assembly to the screen during the first paste deposition is less than a force applied by the squeegee of the first processing head assembly to the screen during the second paste deposition.

17. The method according to claim 13, further comprising:
replacing another to-be-printed substrate after printing is completed; and
controlling the printing apparatus to move from the second side to the first side of the screen, to complete first paste deposition and second paste deposition on the another to-be-printed substrate.

18. The method according to claim 17, wherein the controlling the printing apparatus to move from the second side to the first side of the screen, to complete first paste deposition and second paste deposition on the another to-be-printed substrate comprises:
raising the squeegee of the first processing head assembly and the squeegee of the third processing head assembly to come out of contact with a surface of the screen; lowering the squeegee of the second processing head assembly and the squeegee of the fourth processing head assembly to come into contact with the surface of the screen; and
controlling the printing apparatus to move from the second side to the first side of the screen, to complete first paste deposition by using the squeegee of the second processing head assembly and complete second paste deposition by using the squeegee of the fourth processing head assembly.

19. The method according to claim 18, wherein an amount of pastes deposited onto the to-be-printed substrate and moved by the squeegee of the second processing head assembly is less than an amount of pastes deposited onto the to-be-printed substrate and moved by the squeegee of the fourth processing head assembly.

20. The method according to claim 13, wherein the squeegee of the first processing head assembly and the squeegee of the fourth processing head assembly are made of a first material, and the squeegee of the second processing head assembly and the squeegee of the third processing head assembly are made of a second material.

21. The method according to claim 20, wherein hardness of the second material is greater than hardness of the first material.

22. The method according to claim 21, wherein both the squeegee of the first processing head assembly and the squeegee of the fourth processing head assembly are rubber strip blades; and both the squeegee of the second processing head assembly and the squeegee of the third processing head assembly are steel blades.

23. The method according to claim 18, wherein a force applied by the squeegee of the second processing head assembly to the screen during the first paste deposition is less than a force applied by the squeegee of the fourth processing head assembly to the screen during the second paste deposition.

24. The method according to claim 18, wherein during the first paste deposition, an included angle between the screen and the squeegee of the third processing head assembly is in a range of 30 degrees to 90 degrees, and an included angle between the screen and the squeegee of the second processing head assembly is in a range of 30 degrees to 90 degrees; and
during the second paste deposition, an included angle between the screen and the squeegee of the first processing head assembly is in a range of 30 degrees to 90 degrees, and an included angle between the screen and the squeegee of the fourth processing head assembly is in a range of 30 degrees to 90 degrees.

25. The method according to claim 12, wherein the printing apparatus comprises a first processing head assembly having a squeegee and a second processing head assembly having a squeegee; and
the controlling the printing apparatus to move from a first side of the screen to a second side opposite to the first side, to complete first paste deposition and second paste deposition comprises:
lowering the squeegee of the first processing head assembly and the squeegee of the second processing head assembly to come into contact with a surface of the screen, wherein a paste is located on the screen, the paste is respectively arranged in correspondence with the squeegee of the first processing head assembly and the squeegee of the second processing head assembly, and the paste is respectively arranged in front of a movement direction of the squeegee of the first processing head assembly and the squeegee of the second processing head assembly; and
controlling the printing apparatus to move from the first side of the screen to the second side opposite to the first side, to complete first paste deposition by using the squeegee of the second processing head assembly and complete second paste deposition by using the squeegee of the first processing head assembly.

26. The method according to claim 25, further comprising:
replacing another to-be-printed substrate after printing is completed;
locating the screen above the another to-be-printed substrate; and adjusting the printing apparatus, so that the paste is respectively located in front of a direction in which the squeegee of the first processing head assembly and the squeegee of the second processing head assembly are to be moved; and
controlling the printing apparatus to move from the second side to the first side of the screen, to complete first paste deposition and second paste deposition on the another to-be-printed substrate.

27. The method according to claim 2, wherein the controlling a printing apparatus to move on the screen comprises:
controlling the printing apparatus to move from a first side of the screen to a second side opposite to the first side, to implement first paste deposition and first flooding; and
controlling the printing apparatus to move from the second side to the first side of the screen, to implement second paste deposition and second flooding, wherein during the second paste deposition, a second deposition paste is formed on the upper surface of the to-be-printed substrate, and the second deposition paste is at least partially stacked on the first deposition paste.

28. The method according to claim 27, wherein the printing apparatus comprises a first processing head assembly having a flood blade, a second processing head assembly having a squeegee, a third processing head assembly having a squeegee, and a fourth processing head assembly having a flood blade; and
the implementing first paste deposition and first flooding comprises:
lowering the flood blade of the first processing head assembly and the squeegee of the third processing head assembly, so that the squeegee of the third processing head assembly comes into contact with a surface of the screen, and both the squeegee of the second processing head assembly and the flood blade of the fourth processing head assembly are not in contact with the surface of the screen; and controlling the printing apparatus to move from the first side to the second side of the screen; and
implementing paste deposition by using the squeegee of the third processing head assembly, to form a first deposition paste on the upper surface of the to-be-printed substrate; and implementing first flooding on the screen by using the flood blade of the first processing head assembly.

29. The method according to claim 28, wherein the implementing second paste deposition and second flooding comprises:
lowering the squeegee of the second processing head assembly and the flood blade of the fourth processing head assembly, so that the squeegee of the second processing head assembly comes into contact with the surface of the screen; raising the flood blade of the first processing head assembly and the squeegee of the third processing head assembly to come out of contact with the surface of the screen; and controlling the printing apparatus to move from the second side to the first side of the screen, to complete paste deposition by using the squeegee of the second processing head assembly, so that a second deposition paste is formed on the upper surface of the to-be-printed substrate, and the second deposition paste is at least partially stacked on the first deposition paste; and implement second flooding on the screen by using the flood blade of the fourth processing head assembly.

30. The method according to claim 12, wherein the printing apparatus comprises a first processing head assembly having a squeegee, a second processing head assembly having a flood blade, a third processing head assembly having a squeegee, and a fourth processing head assembly having a flood blade.

31. The method according to claim 30, wherein the first processing head assembly, the second processing head assembly, the third processing head assembly, and the fourth processing head assembly are sequentially arranged along a movement direction of the printing apparatus.

32. The method according to claim 31, wherein the controlling the printing apparatus to move from a first side of the screen to a second side, to complete first paste deposition and second paste deposition on the to-be-printed substrate comprises:
lowering the squeegee of the first processing head assembly and the squeegee of the third processing head assembly to come into contact with a surface of the screen; and
controlling the printing apparatus to move from the first side to the second side of the screen, to complete first paste deposition by using the squeegee of the third processing head assembly and complete second paste deposition by using the squeegee of the first processing head assembly, wherein the second deposition paste is at least partially stacked on the first deposition paste.

33. The method according to claim 32, wherein after the completing first paste deposition and second paste deposition, the method further comprises:
raising the squeegee of the first processing head assembly and the squeegee of the third processing head assembly to come out of contact with the surface of the screen, and lowering the flood blade of the second processing head assembly and the flood blade of the fourth processing head assembly; and
controlling the printing apparatus to move from the second side to the first side of the screen, and complete flooding by using the flood blade of the second processing head assembly and the flood blade of the fourth processing head assembly.

34. The method according to claim 2, wherein no heat treatment process is performed between two paste deposition processes.

35. A printing device, wherein the printing device uses the method for screen printing on a substrate according to any one of claims 1 to 34.

36. A solar cell, wherein the solar cell is prepared by using the method for screen printing on a substrate according to any one of claims 1 to 34.

37. A solar cell assembly, wherein the solar cell assembly is prepared by using a plurality of solar cells according to claim 36.
